# EUROPÄISCHE PATENTSCHRIFT

(11) **EP 4 185 828 B1**
(45) Veröffentlichungstag und Bekanntmachung des Hinweises auf die Patenterteilung: **15.05.2024**
(21) Anmeldenummer: 21745826.4
(22) Anmeldetag: 19.07.2021
(51) Int. Cl.: F28D 1/03, F28F 13/12, F28F 3/06, H05K 7/20, H01F 27/10, F28F 21/08, F28F 13/08, F28F 3/12, F28D 21/00, B60L 53/302, B60L 53/22, B60L 53/12, F28F 3/02, H01F 27/02, H01F 38/14

(54) **WÄRMEÜBERTRAGER ZUM KÜHLEN EINER INDUKTIONSLADEEINRICHTUNG SOWIE INDUKTIONSLADEEINRICHTUNG**
HEAT EXCHANGER FOR COOLING OF AN INDUCTIVE CHARGING DEVICE AND INDUCTIVE CHARGING DEVICE
ÉCHANGEUR DE CHALEUR POUR REFROIDIR UN DISPOSITIF DE CHARGE INDUCTIVE ET DISPOSITIF DE CHARGE INDUCTIVE

(30) Priorität: 21.07.2020 DE 102020209125
(43) Veröffentlichungstag der Anmeldung: 31.05.2023
(73) Patentinhaber: MAHLE International GmbH, 70376 Stuttgart (DE)
(72) Erfinder: WEHOWSKI, Manuel, 74321 Bietigheim-Bissingen (DE)
(74) Vertreter: BRP Renaud & Partner mbB Rechtsanwälte Patentanwälte Steuerberater
(86) Internationale Anmeldenummer: PCT/EP2021/070151
(87) Internationale Veröffentlichungsnummer: WO 2022/018027

(56) Entgegenhaltungen:
- EP-A1- 3 419 031
- CN-U- 201 898 434
- DE-U1-202007 017 501
- US-A1- 2013 112 388
- US-A1- 2017 253 129
- US-A1- 2017 338 023
- US-A1- 2019 360 764
- US-B2- 10 655 922

## Beschreibung

Die Erfindung betrifft einen Wärmeübertrager zum Kühlen einer Induktionsladeeinrichtung gemäß dem Oberbegriff des Anspruchs 1 und ferner eine kraftfahrzeugseitige Induktionsladeeinrichtung gemäß dem Oberbegriff des Anspruchs 15.

Gattungsgemäße Wärmeübertrager sind beispielsweise in der US 2019/360764 A1 und US 2013/112388 A1 beschrieben. Weiterhin sind gattungsgemäße Induktionsladeeinrichtungen beispielsweise aus US 2017/338023 A1, US 2017/253129 A1 und EP 3 419 031 A1 bekannt.

Die Erfindung hat es sich zur Aufgabe gemacht, einen verbesserten Wärmeübertrager oder zumindest eine andere Ausführungsform für einen Wärmeübertrager zum Kühlen einer Induktionsladeeinrichtung bereitzustellen. Insbesondere hat sich die Erfindung die Aufgabe gegeben, eine Induktionsladeeinrichtung mit einem Kühlelement auszurüsten.

Bei der vorliegenden Erfindung wird diese Aufgabe insbesondere durch die Gegenstände der unabhängigen Ansprüche gelöst. Vorteilhafte Ausführungsformen sind Gegenstand der abhängigen Ansprüche und der Beschreibung.

Der Grundgedanke der Erfindung liegt darin, einen relativ kühlleistungsfähigen und relativ kompakten Wärmeübertrager zum Kühlen einer Induktionsladeeinrichtung eines Kraftfahrzeuges bereitzustellen.

Erfindungsgemäß ist hierzu ein Wärmeübertrager zum Kühlen einer Induktionsladeeinrichtung eines Kraftfahrzeuges vorgesehen, welcher zwei separate miteinander verbundene, insb. verlötete, metallische Basisplatten aufweist. Diese beiden Basisplatten bilden oder begrenzen ein ebenes einstückiges Wärmeübertragergehäuse und einen Strömungskanal, durch den sich ein Strömungspfad für ein Wärmeübertragerfluid erstreckt. Der Strömungskanal wiederum hat längs des Strömungspfads von Wärmeübertragerfluid durchströmbare separate Kanalpassagen, die zweckmäßigerweise jeweils stromab und stromauf in eine unmittelbar in Richtung des Strömungspfads benachbart abgeordnete Kanalpassage einmünden. Diese Kanalpassagen haben jeweils einen bezüglich des Strömungspfads quer orientierten freien, insb. konstanten oder variablen, Strömungsquerschnitt, wobei die Strömungsquerschnitte sogenannter erster Kanalpassagen dieser Kanalpassagen flächenkleiner gestaltet sind als die Strömungsquerschnitte sogenannter zweiter Kanalpassagen dieser Kanalpassagen. Damit hat der besagte Strömungskanal zweckmäßigerweise wenigstens zwei unterschiedliche Typen von Kanalpassagen. Um innerhalb des Strömungskanals insb. ein günstiges Strömungsbild bereitzustellen, beispielsweise eine turbulente Strömung, weist der Wärmeübertrager eine vollständig in den Strömungskanal eingesetzte und vom Wärmeübertragerfluid durchströmbare Strömungsleitanordnung zum Leiten des Wärmeübertragerfluids auf.

Zweckmäßigerweise wird der Fachmann den Begriff "flächenkleiner" in dem Sinne deuten, dass die einen Strömungsquerschnitte jeweils eine kleinere Querschnittsfläche haben als die jeweiligen anderen Strömungsquerschnitte. Dadurch sind die Strömungsquerschnitte der Kanalpassagen flächenmäßig unterschiedlich groß gestaltet. Weiter zweckmäßigerweise ist das durch den Strömungskanal beförderte Wärmeübertragerfluid-Volumen pro Zeiteinheit (insb. Sekunde), sprich der Volumenstrom des Wärmeübertragerfluids, konstant eingestellt oder mittels einer geeigneten Wärmeübertragerfluid-Fördereinrichtung des Wärmeübertragers einstellbar. Zweckmäßig bewirken der konstante Volumenstrom des Wärmeübertragerfluids und die unterschiedlichen Strömungsquerschnitte der Kanalpassagen des Strömungskanals den strömungsmechanischen Effekt, dass das Wärmeübertragerfluid mit unterschiedlichen Strömungsgeschwindigkeiten durch den Strömungskanal strömt, nämlich insb. in Abhängigkeit des jeweiligen Strömungsquerschnitts. Beispielsweise wird es die relativ weiten zweiten Kanalpassagen relativ großen Strömungsquerschnitts mit relativ geringer Strömungsgeschwindigkeit durchströmen, während es die relativ engen ersten Kanalpassagen relativ kleinen Strömungsquerschnitts mit vergleichsweise hoher Strömungsgeschwindigkeit durchströmt. Die unterschiedlichen Strömungsgeschwindigkeiten des Wärmeübertragerfluids im Strömungskanal haben Einfluss auf das Wärmeübertragungsverhalten des Wärmeübertragers und/oder zweckmäßigerweise auf den zwischen einer Wärmequelle und dem Wärmeübertragerfluid übertragbaren Wärmestrom. Die Erfindung hat erkannt, dass in den vergleichsweise mit hoher Strömungsgeschwindigkeit durchströmten relativ engen ersten Kanalpassagen relativ kleinen Strömungsquerschnitts eine verbesserte Wärmeübertragung erfolgen kann, während in den vergleichsweise mit geringer Strömungsgeschwindigkeit durchströmten relativ weiten zweiten Kanalpassagen relativ großen Strömungsquerschnitts ein relativ geringer Druckverlust - mithin optimale Strömungseigenschaften für das Wärmeübertragerfluid - erzielbar ist. Die erfindungsgemäße Strömungsleitanordnung dient dazu die Wärmeübertragung zwischen Wärmeübertragerfluid und Basisplatten zu verbessern und das Wärmeübertragerfluid mit einem vorgegebenen oder vorgebbaren Strömungsbild auszustatten, bspw. eine für Wärmeübertragung vorteilhafte turbulente Strömung. Ferner kann die Strömungsleitanordnung die mechanische Steifigkeit des Wärmeübertragers verbessern, bspw. kann die Strömungsleitanordnung das Wärmeübertragergehäuse versteifen, wodurch dieses widerstandsfähiger gegen äußere Kraftbelastungen ist. Alle diese Effekte zusammengenommen haben den gemeinsamen Vorteil, dass der erfindungsgemäße Wärmeübertrager relativ gut an eine Wärmequelle angepasst oder anpassbar und relativ kompakt herzustellen ist.

Zweckmäßigerweise nutzt man diese vorteilhaften Eigenschaften des erfindungsgemäßen Wärmeübertragers bei Induktionsladevorrichtungen für Kraftfahrzeuge, um im Betrieb der Induktionsladevorrichtungen für ausreichend Kühlung zu sorgen. Induktionsladevorrichtungen für Kraftfahrzeuge im Sinne der vorliegenden Erfindung bestehend aus einer kraftfahrzeugseitig installierbaren Induktionseinrichtung, sozusagen die mobile Komponente einer Induktionsladevorrichtung, sowie aus einer fahrbahnseitigen oder bodenseitigen Gegeninduktionseinrichtung, die in der Regel eine stationäre Komponente der Induktionsladevorrichtung bildet. Der erfindungsgemäße Wärmeübertrager kann beispielsweise auf vorgegebene Bereiche relativ hoher elektromagnetischer Verluste der Induktionsladeeinrichtung konstruktiv abgestimmt werden, um dort für optimale Kühlung zu sorgen. Denkbar ist auch, dass der erfindungsgemäße Wärmeübertrager an der fahrbahnseitigen Gegeninduktionseinrichtung zum Einsatz kommen kann.

Weiter zweckmäßigerweise kann die Strömungsleitanordnung separate und jeweils einstückig gestaltete Leitelemente aufweisen. Dabei handelt es sich vorzugsweise um mehrere separate, d.h. insb. vollständig voneinander getrennte, Leitelemente, welche zum Führen des Wärmeübertragerfluids und zur Optimierung der Wärmeleiteigenschaften dienen. Die Leitelemente sind jeweils einstückig gestaltet, dadurch bilden sie jeweils sozusagen eine zusammenhängende Baueinheit. Die Leitelemente können dabei ggf. einstückig einteilig, bspw. aus einem einzigen Werkstoff, oder einstückig mehrteilig, bspw. aus mehreren verschiedenen Werkstoffen, hergestellt sein. Die Leitelemente können unmittelbar mit dem Wärmeübertragerfluid strömungsbegünstigend zusammenwirken.

Zweckmäßigerweise kann in jede der ersten Kanalpassagen dieser Kanalpassagen oder in jede der zweiten Kanalpassagen dieser Kanalpassagen oder in jede der ersten und zweiten Kanalpassagen dieser Kanalpassagen jeweils ein einziges Leitelement eingesetzt sein. Dadurch sind entweder alle ersten Kanalpassagen oder alle zweiten Kanalpassagen oder alle Kanalpassagen mit Leitelementen ausgerüstet. Das hat den Vorteil, dass die Wärmeübertragung in diesen Kanalpassagen verbessert ist. Ferner ist die Steifigkeit dieser Kanalpassagen verbessert. Insb. kann vorgesehen sein, dass in den ersten oder zweiten Kanalpassagen dieser Kanalpassagen jeweils mehr als ein einziges Leitelement eingesetzt ist.

Weiter zweckmäßigerweise sind die Leitelemente jeweils an der einen und/oder anderen Basisplatte formschlüssig und/oder kraftschlüssig wärmeleitend fixiert. Vorzugsweise kann man die Leitelemente an der einen und/oder anderen Basisplatte mittels Befestigungsschrauben fixieren. Weiter vorzugsweise kann man die Leitelemente an der einen und/oder anderen Basisplatte mittels Rastelementen fest einrasten. Zweckmäßigerweise sind die Leitelemente damit bezüglich der Basisplatten unbeweglich.

Zweckmäßigerweise sind die Leitelemente jeweils an der einen und/oder anderen Basisplatte stoffschlüssig fixiert. Vorzugsweise kann man die Leitelemente jeweils an einer der beiden Basisplatten durch Löten fixieren. Dies kann ggf. durch Verwendung eines geeigneten Lotmaterials unterstützt werden. Weiter vorzugsweise, kann man die Leitelemente jeweils an einer der beiden Basisplatten durch Kleben fixieren. Zweckmäßigerweise sind die Leitelemente damit bezüglich der Basisplatten unbeweglich.

Weiter zweckmäßigerweise begrenzen oder bilden die Leitelemente jeweils parallel zueinander ausgerichtete Leitkanäle, welche jeweils eine Kanallängsachse definieren, wobei sich durch diese Leitkanäle jeweils der Strömungspfad für das Wärmeübertragerfluid erstreckt, so dass die Leitkanäle jeweils von Wärmeübertragerfluid durchströmbar sind. Durch die Leitkanäle kann das Wärmeübertragerfluid geleitet bzw. geführt werden. Das hat den Vorteil, dass das Wärmeübertragerfluid gerichtet und die Wärmeübertragung in diesem Bereich verbessert ist.

Zweckmäßigerweise münden die Leitkanäle eines jeweiligen Leitelements einenends und anderenends in eine erste Kanalpassage dieser Kanalpassagen oder in eine zweite Kanalpassage dieser Kanalpassagen. Dadurch kann das Wärmeübertragerfluid von den Leitkanälen ausgehend entweder in die ersten oder in die zweiten Kanalpassagen strömen.

Weiter zweckmäßigerweise begrenzen oder bilden die Leitkanäle eines jeweiligen Leitelements jeweils einen durchströmbaren freien Leitquerschnitt, welcher bezüglich der Kanallängsachse dieses Leitkanals quer orientiert und flächenmäßig konstant und rechteckig, viereckig oder vieleckig ist.

Zweckmäßigerweise können die Leitelemente jeweils in einer Trapezform ausgeführt sein. Dabei bietet es sich in der Praxis an, die jeweiligen Leitelemente als Gleichteile zu realisieren, also diese jeweils baugleich auszuführen. Zweckmäßig können die jeweiligen Leitelemente dabei aus einem Aluminiumwerkstoff hergestellt sein. Der Begriff "Aluminiumwerkstoff" kann dabei sowohl reines Aluminiummaterial als auch beliebige Aluminiumlegierungen umfassen. Metallische, insb. aluminiumhaltige, Leitelemente können einen elektromagnetischen Abschirmeffekt generieren. Insb. können die jeweiligen Leitelemente aus einem gewellten oder gefalteten oder plissierten Blechwerkstoff hergestellt sein.

Weiter zweckmäßigerweise sind die besagten Strömungsquerschnitte der ersten Kanalpassagen dieser Kanalpassagen zueinander flächengleich, also flächengrößenmäßig identisch. Gleiches kann für die Strömungsquerschnitte der zweiten Kanalpassagen dieser Kanalpassagen angedacht sein, nämlich dass diese zueinander flächengleich, also flächengrößenmäßig identisch, sind. Dadurch hat der Strömungskanal zwei eindeutig abgrenzbare unterschiedliche Kanalpassagen-Typen. Diese Kanalpassagen lassen sich relativ einfach herstellen.

Zweckmäßigerweise haben oder bedecken die Strömungsquerschnitte der ersten Kanalpassagen dieser Kanalpassagen flächenmäßig jeweils lediglich 9/10 oder 8/10 oder 7/10 oder 6/10 oder 5/10 oder 4/10 oder 3/10 oder 2/10 oder 1/10 der Fläche des Strömungsquerschnitts einer zweiten Kanalpassage dieser Kanalpassagen. Das hat den vorteilhaften Effekt, dass die Strömungsgeschwindigkeit des Wärmeübertragerfluid in den relativ engen ersten Kanalpassagen relativ kleinen Strömungsquerschnitts relativ hoch ist. Dies führt zu einem verbesserten Wärmetransport in den Randbereichen der Ferrite, wo auch eine erhöhte Abwärme anfällt.

Weiter zweckmäßigerweise sind die ersten Kanalpassagen dieser Kanalpassagen und die zweiten Kanalpassagen dieser Kanalpassagen längs des Strömungspfads in alternierend abwechselnder Reihenfolge aufeinanderfolgend. Dadurch folgt bspw. auf eine erste Kanalpassage stets eine zweite Kanalpassage, oder umgekehrt. Dabei ist es zweckmäßig, die eine Kanalpassage in die andere einmünden zu lassen, so dass Wärmeübertragerfluid von der einen in die nächst Kanalpassage strömen kann. Die Kanalpassagen können dadurch sozusagen fluidisch miteinander kommunizieren. Dies ermöglicht im Gesamten ein relativ gutes Wärmeübertragungsverhalten des Wärmeübertragers, bei gleichzeitig optimiertem Druckverlust.

Ferner ist es zweckmäßig, wenn das Wärmeübertragergehäuse als Ringgehäuse oder als Vieleckgehäuse ausgeführt ist. Allerdings können auch - wo es der Sache dienlich ist - abweichende weitere geometrische Gehäuseformen in Frage kommen. Der Strömungskanal bildet in diesen Fällen einen ebenen Ringkanal, durch den sich ein ebenfalls ringförmiger Strömungspfad für das Wärmeübertragerfluid erstreckt. In Fachkreisen kann dies auch unter dem Begriff "U-Flow" bezeichnet sein. Insb. kann sich der Strömungspfad kreisförmig oder im Wesentlichen kreisförmig oder u-förmig um eine senkrecht auf den Basisplatten des Wärmeübertragergehäuses stehende bezüglich des Ringkanals mittig angeordnete Gehäusemittenachse erstrecken. Das besagte Wärmeübertragergehäuse kann kuchenartig in die jeweiligen Kanalpassagen aufgeteilt sein, insb. können die besagten Kanalpassagen dadurch eine dem jeweiligen Wärmeübertragergehäuse entsprechende Ausschnittsform haben. Beispielsweise sind sie kreisausschnittförmig oder vieleckausschnittförmig gestaltet, so dass sie gemeinsam das entsprechende Wärmeübertragergehäuse bilden können. Dadurch kann der Wärmeübertrager im Gesamten relativ kompakt ausgeführt werden, wodurch bspw. die Montage in einem Kraftfahrzeug oder in einer Induktionsladevorrichtung für ein Kraftfahrzeug begünstigt ist.

Weiter zweckmäßigerweise kann der Wärmeübertrager zwei Kanalpassagen aufweisen, welche durch zwei am Wärmeübertragergehäuse fixierte oder angeordnete Anschlussstutzen gebildet sind. Dabei bildet der eine erste Anschlussstutzen einen Fluideinlass und der andere zweite Anschlussstutzen einen Fluidauslass. Mittels des Fluideinlasses kann Wärmeübertragerfluid in den Strömungskanal eingeströmt werden, mittels des Fluidauslasses kann Wärmeübertragerfluid aus dem Strömungskanal ausgeströmt werden. Insb. kann der Fluideinlass und der Fluidauslass nebeneinanderliegen und/oder jeweils in die zweite Kanalpassage dieser Kanalpassagen einmünden, so dass Wärmeübertragerfluid sozusagen in eine der relativ weiten zweiten Kanalpassagen relativ großen Strömungsquerschnitts einströmen kann bzw. über diese ausströmen kann. Insb. kann diese zweite Kanalpassage mit einem Leitelement ausgerüstet sein. Zweckmäßigerweise ist dieses eine Leitelement auf den Fluideinlass und den Fluidauslass abgestimmt, beispielsweise kann es einen Bereich rund um den Fluideinlass und den Fluidauslass freilassen, so dass Wärmeübertragerfluid strömungsgünstig einströmen kann.

Die Erfindung kann den alternativen oder zusätzlichen weiteren Grundgedanken umfassen, eine kraftfahrzeugseitige Induktionsladeeinrichtung anzugeben, welche in einer zum Aufladen einer Traktionsbatterie eines Kraftfahrzeugs dienenden Induktionsladevorrichtung betreibbar ist. Insb. soll eine derartige Induktionsladeeinrichtung mit einem Kühlelement ausgestattet werden, um eine vorgegebene Kühlleistung bereitzustellen und/oder um die Induktionsladeeinrichtung ausreichend zu kühlen, sowie einen optimierten Druckverlust des Wärmeübertragerfluids zu realisieren.

Hierzu ist eine Induktionsladeeinrichtung vorgesehen, welche kraftfahrzeugseitig an einem Kraftfahrzeug montierbar und sozusagen als Bestandteil in einer Induktionsladevorrichtung zum Aufladen einer Traktionsbatterie eines Kraftfahrzeugs einsetzbar oder betreibbar ist. Die erfindungsgemäße Induktionsladeeinrichtung hat einen unterbodenseitig in ein Kraftfahrzeug einbaubaren ebenen Spulenträger, welcher eine elektrisch kontaktierte oder kontaktierbare Spule trägt und welcher durch eine Versteifungsanordnung aus wenigstens einem Versteifungskörper, beispielsweise gegen mechanische Belastungen von außen her, versteift ist. Die besagten Versteifungskörper sind jeweils längs zu einer insb. ebenen Trägergroßfläche des Spulenträgers zueinander unter Ausbildung von zunächst freien Zwischenbereichen beabstandet, beispielsweise mehrere Millimeter bis Zentimeter, und sich jeweils an dieser Trägergroßfläche abstützend am Spulenträger fixiert. Dadurch können die Versteifungskörper sozusagen separate Bauteile bilden, die nachträglich - bspw. beanspruchungsabhängig - an den Spulenträger angefügt sind. In jedem dieser besagten Zwischenbereiche ist ein Ferritkörper einer mehrere separate Ferritkörper aufweisenden Ferritanordnung eingelegt, die Zwischenbereiche sind daher jeweils zweckmäßigerweise teilweise gefüllt. Dabei spannen diese Ferritkörper und diese Versteifungskörper eine gemeinsame Ebene auf, welche zweckmäßigerweise parallel oder im Wesentlichen parallel zur Trägergroßfläche angeordnet ist. Die Induktionsladeeinrichtung verfügt ferner über eine Elektronikanordnung aus wenigstens einem Elektronikkörper. Bei den Elektronikkörpern kann es sich insb. um Leistungselektronik für die Induktionsladeeinrichtung handeln. Um eine im Betrieb der Induktionsladeeinrichtung durch Verlustleistung, insb. durch elektromagnetische Verluste und/oder elektrische Widerstandsverluste etc., hervorgerufene Erwärmung der Induktionsladeeinrichtung in einem vorgegebenen Betriebsfenster zu halten, verfügt die Induktionsladeeinrichtung über wenigstens ein Kühlelement, das zum Kühlen der Induktionsladeeinrichtung dient. Zweckmäßig ist dabei, wenn das Kühlelement relativ nahe an Orten relativ hoher Verluste angeordnet ist, sprich an Orten mit relativ hoher Temperaturbelastung. Dazu ist das Kühlelement in Richtung einer senkrecht auf der Trägergroßfläche stehenden Querachse zwischen einerseits der Ferritanordnung, der Versteifungsanordnung und dem Spulenträger sowie andererseits der Elektronikanordnung sandwichartig zwischengeschaltet. Den Begriff "Sandwichartig" kann der Fachmann dabei im Sinne einer unmittelbaren, lagenartigen Anordnung verstehen. Dadurch wird erreicht, dass die Elektronikanordnung durch das Kühlelement gegenüber der Ferritanordnung, der Versteifungsanordnung und dem Spulenträger abgegrenzt und elektromagnetisch abschirmbar oder abgeschirmt und kühlbar ist. Damit die besagten Komponenten über die gesamte Lebensdauer der Induktionsladeeinrichtung beieinander bleiben und relativ zueinander unbeweglich sind, sind die Ferritanordnung, die Versteifungsanordnung, der Spulenträger und das Kühlelement jeweils wenigstens abschnittsweise durch eine Wärmeleiteigenschaften aufweisende Vergussmasse aneinander fixiert, beispielsweise kann man hier von einer Verklebung sprechen. Dadurch ist eine vorteilhafte Induktionsladeeinrichtung beschrieben, die sich insb. durch eine relativ kleine Bauhöhe und durch ein Kühlelement mit relativ hoher Kühlleistung auszeichnet.

Die beschriebene Induktionsladeeinrichtung ist - wie oben angedeutet - zweckmäßigerweise fahrzeugseitig am Unterboden eines Kraftfahrzeuges angeordnet und Bestandteil einer übergeordneten Induktionsladevorrichtung. Derartige Induktionsladevorrichtungen für Kraftfahrzeuge im Sinne der vorliegenden Erfindung bestehen jeweils aus der besagten kraftfahrzeugseitig installierbaren Induktionseinrichtung sowie aus einer fahrbahnseitig installierbaren Gegeninduktionseinrichtung. Die entsprechenden Fachkreise kennen besagte Induktionsladeeinrichtung auch unter dem Begriff "Vehicle Assembly System" und besagte Gegeninduktionsladeeinrichtung unter dem Begriff "Ground Assembly System". Die Induktionsladevorrichtungen erlauben es, eine Traktionsbatterie eines Kraftfahrzeugs kontaktlos aufzuladen. Dabei ist die Gegeninduktionsladeeinrichtung über eine nicht näher erläuterte Gegenspule und ein damit bereitgestelltes pulsierendes Magnetfeld in bekannter Weise induktiv mit der Spule der Induktionsladeeinrichtung gekoppelt. Während des Aufladens der Traktionsbatterie entstehen zumindest innerhalb der Induktionsladeeinrichtung Wärmeverluste, welche eine allmähliche Erwärmung der Induktionsladeeinrichtung verursachen. Um eine ausreichende Kühlung bereitzustellen, ist das Kühlelement vorgesehen, welches die Erwärmung der Induktionsladeeinrichtung in vorgegebenen zulässigen Erwärmungsbereichen hält. Zweckmäßigerweise kann das Kühlelement, insbesondere ein Wärmeübertrager nach der vorangehenden Beschreibung, auch an einer Gegeninduktionsladeeinrichtung erfolgreich zum Kühlen eingesetzt werden.

Zweckmäßigerweise können die besagten Versteifungskörper auch als Positionierhilfen für das Positionieren der Ferritkörper dienen.

Weiter ist vorgesehen, dass das besagte Kühlelement der Induktionsladeeinrichtung ein Wärmeübertrager nach der vorangehenden Beschreibung ist. Möglich ist auch, dass das Kühlelement mehrere Wärmeübertrager nach der vorangehenden Beschreibung aufweist, beispielsweise um weitere Komponenten der Induktionsladeeinrichtung zu kühlen. Um den oder zweckmäßigerweise die besagten Wärmeübertrager an die übrigen Komponenten der Induktionsladeeinrichtung anzubinden, ist eine erste Basisplatte der beiden Basisplatten des Wärmeübertragers mittels der besagten nun eine Basisplattengroßfläche der ersten Basisplatte vollständig bedeckenden Vergussmasse an der Ferritanordnung, der Versteifungsanordnung und dem Spulenträger angeordnet, beispielsweise dauerhaft fixiert.

Die erste Basisplatte der beiden Basisplatten weist dabei Rücksprünge, insbesondere sogenannte Rücksprungabschnitte, und Basisabschnitte auf.

Alternativ kann die andere, zweite Basisplatte der Basisplatten oder die erste und zweite Basisplatte Rücksprünge, insbesondere sogenannte Rücksprungabschnitte, und Basisabschnitte aufweisen. Die besagten Rücksprünge könnte man auch als Vertiefungen, Sicken oder Rillierungen beschreiben, welche bezüglich der Basisabschnitte in die jeweilige Basisplatte des Wärmeübertragers eingebracht sind. Im zusammengebauten Zustand der Induktionsladeeinrichtung liegen diese Rücksprünge zweckmäßigerweise den Bereichen relativ hoher elektromagnetischer Verluste gegenüber, wie sie z.B. im Randbereich der Ferrite vorliegen. Durch die Rücksprünge werden insbesondere durch den erhöhten Abstand Abschirmverluste reduziert.

Weiter zweckmäßigerweise können die Rücksprünge und Basisabschnitte im Bereich der Basisplattengroßfläche der ersten Basisplatte angeordnet sein und diese Großfläche segmentieren. Ggf. bilden die Rücksprünge und die Basisabschnitte die besagte Basisplattengroßfläche. Damit sind die Rücksprünge und Basisabschnitte vorzugsweise lediglich im mit Vergussmasse bedeckten Bereich der Basisplattengroßfläche angeordnet. Die Rücksprünge können zweckmäßig in Richtung der Querachse vom Spulenträger wegweisen, bezüglich der Basisplattengroßfläche der ersten Basisplatte in Richtung der Querachse weg vom Spulenträger eingerückt sein und weiterhin jeweils in Richtung der Querachse einem Versteifungskörper der Versteifungsanordnung gegenüberliegen. Damit ist sozusagen jedem Rücksprung genau ein Versteifungskörper zugeordnet. Die Basisabschnitte können zweckmäßig jeweils in Richtung der Querachse einem Ferritkörper der Ferritanordnung gegenüberliegen. Die Basisabschnitte liegen zweckmäßigerweise auf dem gleichen Höhennivau wie die Basisplattengroßfläche. Zweckmäßigerweise definieren die Basisabschnitte die Basisplattengroßfläche.

Jedenfalls ist weiterhin zweckmäßig, wenn ein erster Abstand in Richtung der Querachse zwischen einem jeweiligen Rücksprung und der besagten Ebene und/oder einem jeweiligen Versteifungskörper größer ist als ein zweiter Abstand in Richtung der Querachse zwischen einem jeweiligen Basisabschnitt und der besagten Ebene und/oder einem jeweiligen Ferritkörper. Damit ist zwischen den Rücksprüngen und den Versteifungskörpern bzw. der Ebene jeweils ein vergleichsweise großer (erster) Abstand gebildet, dieser kann mit Vergussmasse aufgefüllt sein, was Wärmeleiteigenschaften und elektromagnetische Abschirmungen begünstigt. Dagegen ist der andere (zweite) Abstand zwischen den Basisabschnitten und den Ferritkörpern bzw. der Ebene vergleichsweise klein, wodurch in diesem Bereich Wärmeleiteigenschaften begünstigt sind.

Zweckmäßigerweise können die besagten Rücksprünge der ersten Basisplatte der beiden Basisplatten gemeinsam mit der in Richtung der Querachse gegenüberliegenden zweiten Basisplatte der beiden Basisplatten die ersten Kanalpassagen der Kanalpassagen des Wärmeübertragers begrenzen oder bilden. Die besagten Basisabschnitte der ersten Basisplatte der beiden Basisplatten können dabei gemeinsam mit der in Richtung der Querachse gegenüberliegenden zweiten Basisplatte der beiden Basisplatten die zweiten Kanalpassagen der Kanalpassagen des Wärmeübertragers begrenzen oder bilden. Dies hat den vorteilhaften Effekt, dass die Bereiche relativ hoher elektromagnetischer Verluste relativ gut kühlbar sind.

Zweckmäßigerweise ist der Spulenträger ein nichtmetallischer Spulenträger.

Zusammenfassend bleibt festzuhalten: Die vorliegende Erfindung betrifft vorzugsweise einen Wärmeübertrager für eine Induktionsladeeinrichtung eines Kraftfahrzeuges, mit zwei Basisplatten, welche ein Wärmeübertragergehäuse und einen Strömungskanal bilden, durch den sich ein Strömungspfad für ein Wärmeübertragerfluid erstreckt, wobei der Strömungskanal längs des Strömungspfads Kanalpassagen aufweist, die jeweils einen bezüglich des Strömungspfads quer orientierten Strömungsquerschnitt haben, wobei Strömungsquerschnitte erster Kanalpassagen dieser Kanalpassagen flächenkleiner gestaltet sind als Strömungsquerschnitte zweiter Kanalpassagen dieser Kanalpassagen und mit einer in den Strömungskanal eingesetzten Strömungsleitanordnung zum Leiten des Wärmeübertragerfluids. Die vorliegende Erfindung betrifft eine Induktionsladeeinrichtung mit einem Kühlelement.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch
- Fig. 1: in einer Draufsicht einen erfindungsgemäßen Wärmeübertrager gemäß einem bevorzugten Ausführungsbeispiel, eine Basisplatte des Wärmeübertragers ist entfernt, um den Blick in das Innere des Wärmeübertragers freizugeben,
- Fig. 2: eine Schnittansicht des Wärmeübertragers aus Fig. 1 nach einer dort eingezeichneten Schnittlinie II-II,
- Fig. 3: einerseits in einer mit dem Buchstaben A bezeichneten Seitenansicht ein einzelnes Leitelement einer Strömungsleitanordnung des Wärmeübertragers aus Fig. 1 sowie andererseits in einer mit dem Buchstaben B bezeichneten Draufsicht mehrere Leitelemente der Strömungsleitanordnung des Wärmeübertragers aus Fig. 1 im Rahmen eines Herstellungsschrittes sowie zuletzt
- Fig. 4: in einer weiteren Schnittansicht eine erfindungsgemäße Induktionsladeeinrichtung gemäß einem bevorzugten Ausführungsbeispiel mit einem Wärmeübertrager nach den Fig. 1 bis 3.

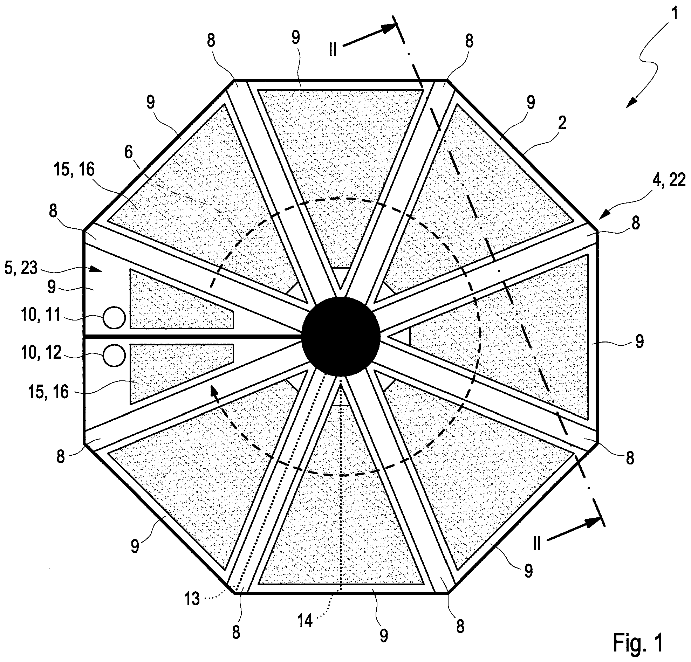

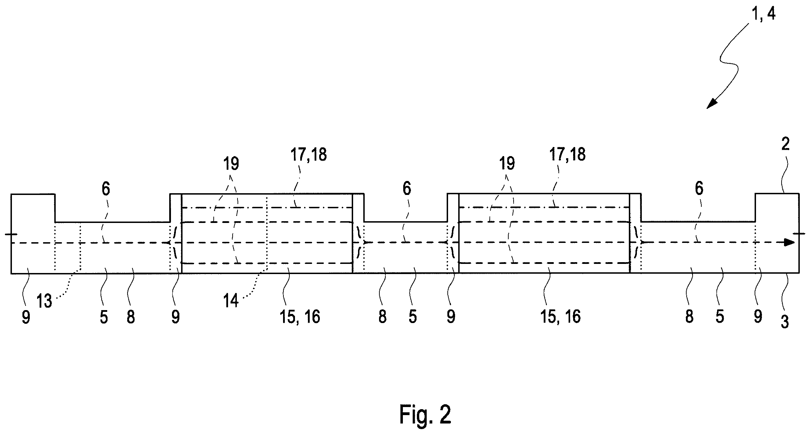

Die Fig. 1 und 2 zeigen einen im Gesamten mit der Ziffer 1 bezeichneten Wärmeübertrager gemäß eines bevorzugten Ausführungsbeispiels. Derartige Wärmeübertrager 1 dienen typischerweise dazu, Wärmeenergie aus einem vorgegebenen - zu kühlenden - beliebigen System mit einer Wärmequelle abzuführen. Dazu ist vorliegend vorgesehen, ein vorgegebenes System mit einem Wärmeübertrager 1 auszurüsten, welcher von einem Wärmeübertragerfluid durchströmt wird, wobei beim Durchströmen Wärmeenergie von Komponenten des vorgegebenen Systems auf das Wärmeübertragerfluid übertragen wird, insb. durch Wärmeleitung. Das Wärmeübertragerfluid ist zweckmäßigerweise eine Flüssigkeit oder ein Gas. Der nachfolgend beschriebene Wärmeübertrager 1 kann bspw. in einer Induktionsladeeinrichtung 24 eines Kraftfahrzeugs eingesetzt werden, um dort für ausreichende Kühlung zu sorgen. Grundsätzlich können aber auch andere Systeme vorgegeben sein.

Die Fig. 1 zeigt einen erfindungsgemäßen Wärmeübertrager 1 in einer Draufsicht, wobei der Wärmeübertrager 1 einseitig offen ist, um den Blick in das Innere des Wärmeübertragers 1 freizugeben. Der Wärmeübertrager 1 weist zwei separate einstückige Basisplatten 2,3 auf, siehe auch Fig. 2. Beispielsweise handelt es sich bei den Basisplatten 2,3 um Aluminiumblechplatten. Die Basisplatten 2,3 sind exemplarisch dauerhaft miteinander verlötet, so dass sie infolge einerseits ein mit der Ziffer 4 bezeichnetes einstückiges Wärmeübertragergehäuse, exemplarisch ein Vieleckgehäuse 22, sowie andererseits einen freien Strömungskanal 5, exemplarisch ein Ringkanal 23, bilden oder begrenzen. Durch den Strömungskanal 5 erstreckt sich ein kreisförmiger Strömungspfad 6 für ein Wärmeübertragerfluid. Der Strömungspfad 6 ist in Fig. 1 mit einer gestrichelten Linie grob angedeutet.

Der Strömungskanal 5 gemäß Fig. 1 und 2 ist längs des Strömungspfads 6 von in Richtung des Strömungspfeils 6 alternierend aufeinanderfolgenden ersten und zweiten Kanalpassagen 8,9 gebildet, die jeweils einen bezüglich des Strömungspfads 6 quer orientierten freien konstanten Strömungsquerschnitt 13,14 haben und jeweils von Wärmeübertragerfluid durchströmbar sind. In Fig. 1 und 2 sind die Strömungsquerschnitte 13,14 jeweils lediglich einmal und jeweils durch eine punktierte Linie angedeutet. Zweckmäßigerweise münden die Kanalpassagen 8,9 stromab und stromauf in eine unmittelbar in Richtung des Strömungspfads 6 benachbart abgeordnete Kanalpassage 8,9 ein, so dass Wärmeübertragerfluid von der einen zur anderen Kanalpassage 8,9 überströmen kann. Damit ist es möglich, dass der Strömungskanal 5 längs des Strömungspfads 6 vollständig durchströmbar ist.

In der Draufsicht nach Fig. 1 kann man ferner erkennen, dass die Kanalpassagen 8,9 exemplarisch jeweils in etwa eine dreieckige Grundform haben. Sie geben damit dem Ringkanal 23 und sozusagen auch dem Vieleckgehäuse 22 eine vieleckige Form. Grundsätzlich kann der Wärmeübertrager 1 bzw. das Wärmeübertragergehäuse 4 auch in anderen geometrischen Formen gestaltet sein.

Der Wärmeübertrager 1 verfügt über weitere Kanalpassagen, die vorliegend mit der Ziffer 10 bezeichnet und als Anschlussstutzen benannt sind, welche am Wärmeübertragergehäuse 4, also an einer der beiden Basisplatten 2,3, fixiert sind. Exemplarisch ist vorgesehen, dass der eine Anschlussstutzen 10 einen Fluideinlass 11 und der andere Anschlussstutzen 10 einen Fluidauslass 12 bildet, um dadurch Wärmeübertragerfluid sowohl in den Strömungskanal 5 einzuströmen als auch auszuströmen.

Die Strömungsquerschnitte 13,14 sind exemplarisch so gewählt, dass die Strömungsquerschnitte 13 der ersten Kanalpassagen 8 der beiden Kanalpassagen 8,9 jeweils zueinander flächenmäßig gleich groß sind. Auch die Strömungsquerschnitte 14 der zweiten Kanalpassagen 9 der beiden Kanalpassagen 8,9 sind so ausgeführt, dass sie jeweils zueinander flächenmäßig gleich groß sind. Weiterhin ist vorgesehen, dass Strömungsquerschnitte 13 der ersten Kanalpassagen 8 der beiden Kanalpassagen 8,9 flächenmäßig kleiner gestaltet sind, als diejenigen Strömungsquerschnitte 14 der zweiten Kanalpassagen 9 dieser beiden Kanalpassagen 8,9. Damit sind mithin zwei verschiedene Typen von Kanalpassagen 8,9 definiert, nämlich einerseits relativ querschnittskleinflächige Kanalpassage 8 sowie andererseits relativ querschnittsgroßflächige Kanalpassage 9. Die unterschiedlichen Strömungsquerschnitte 13,14 der beiden Kanalpassagen 8,9 haben - zweckmäßigerweise einen konstanten Volumenstrom des Wärmeübertragerfluids vorausgesetzt - den strömungsmechanischen Effekt, dass das Wärmeübertragerfluid mit unterschiedlichen Strömungsgeschwindigkeiten durch den Strömungskanal 5 strömt, nämlich kann es die relativ weiten zweiten Kanalpassagen 9 relativ großen Strömungsquerschnitts 14 mit relativ geringer Strömungsgeschwindigkeit durchströmen, während es die relativ engen ersten Kanalpassagen 8 relativ kleinen Strömungsquerschnitts 13 mit vergleichsweise hoher Strömungsgeschwindigkeit durchströmt. Insgesamt hat dies Einfluss auf das Wärmeübertragungsverhalten des Wärmeübertragers 1, zweckmäßigerweise auf den zwischen einer Wärmequelle und dem Wärmeübertragerfluid übertragbaren Wärmestrom. Exemplarisch ermöglichen die relativ engen ersten Kanalpassagen 8 relativ kleinen Strömungsquerschnitts 13 eine verbesserte Wärmeabfuhr.

Weiterhin kann man in Fig. 1 und 2 eine in den Strömungskanal 5 vollständig eingesetzte und mit der Ziffer 15 bezeichnete Strömungsleitanordnung erkennen, die vollständig vom Wärmeübertragerfluid durchströmbar ist. Die Strömungsleitanordnung 15 wirkt mit dem Wärmeübertragerfluid zusammen, um einen für die Wärmeübertragung strömungsgünstigen Zustand innerhalb des Strömungskanals 5 bereitzustellen. Exemplarisch hat die Strömungsleitanordnung 15 mehrere separat ausgebildet, jeweils einstückig gestaltete Leitelemente 16, welche in Fig. 1 jeweils durch ein spitz zulaufendes viereckiges Kästchen und in Fig. 2 jeweils durch ein rechteckiges Kästchen angedeutet sind. Die Leitelemente 16 sind exemplarisch in die zweiten Kanalpassagen 9 der Kanalpassagen 8,9 eingesetzt und dort an der einen und/oder anderen Basisplatte 2,3 stoffschlüssig fixiert, nämlich angelötet.

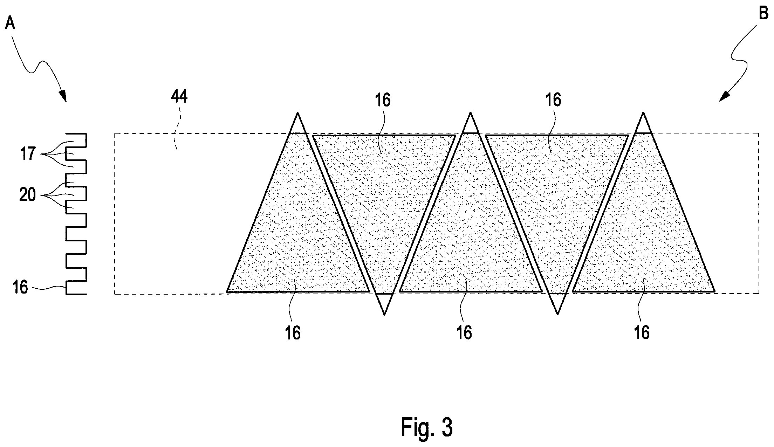

Die Fig. 3 zeigt einerseits in einer mit dem Buchstabe A bezeichneten Seitenansicht ein solches Leitelement 16 der Strömungsleitanordnung 15 sowie andererseits in einer mit dem Buchstabe B bezeichneten Draufsicht mehrere Leitelemente 16 der Strömungsleitanordnung 15 im Rahmen eines Herstellungsschrittes. Die Leitelemente 16 haben mehrere jeweils parallel zueinander ausgerichtete Leitkanäle 17, siehe bei Buchstabe A, welche jeweils entlang ihrer jeweiligen Haupterstreckung eine Kanallängsachse 18 definieren. Die Leitkanäle 17 haben jeweils einen freien rechteckigen Leitquerschnitt 20, siehe Fig. 3, und durch sie erstreckt sich jeweils ein Strömungsteilpfad 19 des Strömungspfads 6 für das Wärmeübertragerfluid, so dass die Leitkanäle 17 bzw. die Leitelemente 16 vom Wärmeübertragerfluid durchströmbar sind. Siehe auch Fig. 2, dort sind exemplarisch Kanallängsachsen 18 mit strichpunktierter Linie sowie mehrere Strömungsteilpfade 19 eingetragen. Die besagten Leitelemente 16 werden zweckmäßigerweise im Rahmen eines Herstellungsschrittes eines nicht näher erläuterten Herstellungsverfahrens aus einem Bandmaterial 44 oder dergleichen zugeschnitten. Hierbei ist es von Vorteil, wenn die Leitelemente 16 als Gleichteile und in einer Trapezform realisiert sind, siehe Fig. 3 bei Buchstabe B.

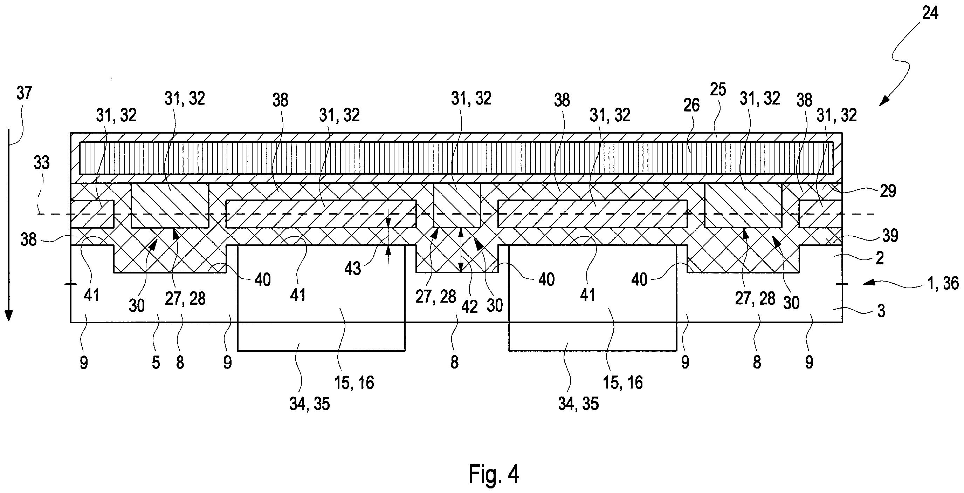

Zuletzt zeigt die Fig. 4 eine Schnittansicht einer erfindungsgemäßen Induktionsladeeinrichtung 24 gemäß eines bevorzugten Ausführungsbeispiels, die zweckmäßigerweise fahrzeugseitig am Unterboden eines nicht illustrierten Kraftfahrzeuges angeordnet werden kann und Bestandteil einer übergeordneten nicht illustrierten Induktionsladevorrichtung ist. Derartige Induktionsladevorrichtungen für Kraftfahrzeuge im Sinne der vorliegenden Erfindung bestehen jeweils aus der besagten kraftfahrzeugseitig installierbaren Induktionseinrichtung 24 sowie aus einer fahrbahnseitig installierbaren nicht illustrierten Gegeninduktionseinrichtung. Dabei ist die Gegeninduktionseinrichtung über eine nicht näher erläuterte Gegenspule und ein damit bereitgestelltes pulsierendes Magnetfeld in bekannter Weise induktiv mit einer Spule 26 der Induktionseinrichtung 24 gekoppelt. Induktionsladevorrichtungen erlauben somit, eine Traktionsbatterie eines Kraftfahrzeugs kontaktlos aufzuladen.

Die Induktionsladeeinrichtung 24 nach Fig. 4 hat einen ebenen Spulenträger 25, der zwei entgegengesetzte Trägergroßflächen bildet und die besagte Spule 26 trägt. Um den Spulenträger 25 und die Spule 26 gegen mechanische Kraftbelastungen zu versteifen ist exemplarisch vorgesehen, dass am Spulenträger 25 eine Versteifungsanordnung 27 aus mehreren Versteifungskörpern 28 angeordnet ist. Zweckmäßigerweise sind die Versteifungskörper 28 an einer Trägergroßfläche 29 der beiden Trägergroßflächen angeordnet und am Spulenträger 25 fixiert sowie längs zu dieser Trägergroßfläche 29 zueinander unter Ausbildung von freien Zwischenbereichen 30 beabstandet. In jeden dieser Zwischenbereiche 30 ist ein Ferritkörper 32 einer mehrere separate Ferritkörper 32 aufweisenden Ferritanordnung 31 eingelegt. Durch diese Anordnung spannen die Ferritkörper 32 und die Versteifungskörper 28 eine gemeinsame Ebene 33 auf, welche exemplarisch parallel zur Trägergroßfläche 29 ist. Die Ebene 33 ist in Fig. 4 durch eine gestrichelte Linie angedeutet. Die Induktionsladeeinrichtung 24 hat darüber hinaus eine Elektronikanordnung 34 aus wenigstens einem Elektronikkörper 35, bspw. um die Induktionsladeeinrichtung 24 zu steuern und/oder zu regeln. Da im regulären Betrieb der Induktionseinrichtung 24 Wärmeverluste an oder in den Komponenten der Induktionseinrichtung 24 auftreten, welche zu einer allmählichen Erwärmung der Induktionseinrichtung 24 führen, ist die Induktionseinrichtung 24 mit einem der ausreichenden Kühlung dienenden Kühlelement 36 ausgestattet. Dieses Kühlelement 36 ist exemplarisch in Richtung einer senkrecht auf der Trägergroßfläche 29 stehenden Querachse 37 zwischen einerseits der Ferritanordnung 31, der Versteifungsanordnung 27 und dem Spulenträger 25 sowie andererseits der Elektronikanordnung 34 sandwichartig zwischengeschaltet. Dadurch kann sowohl die Elektronikanordnung 34 gegenüber der Ferritanordnung 31, der Versteifungsanordnung 27 und dem Spulenträger 25 abgeschirmt sein als auch eine optimale Wärmeenergieabfuhr, sprich eine optimale Kühlung, bewirkt werden. Die Ferritanordnung 31, die Versteifungsanordnung 27, der Spulenträger 25 und das Kühlelement 36 sind vorliegend jeweils abschnittsweise durch eine relativ gute Wärmeleiteigenschaften aufweisende ausgehärtete Vergussmasse 38 unlösbar aneinander fixiert.

Zweckmäßigerweise ist das Kühlelement 36 durch einen einzigen Wärmeübertrager 1 nach der vorangehenden Beschreibung gebildet. Denkbar ist auch, dass das Kühlelement 36 durch zwei oder mehr Wärmeübertrager 1 gebildet ist, bspw. um die Gesamtkühlleistung zu erhöhen.

Nach Fig. 4 ist vorgesehen, dass der gesamte Wärmeübertrager 1 mithilfe der besagten Vergussmasse 38 an der Ferritanordnung 31, der Versteifungsanordnung 27 und dem Spulenträger 25 fixiert Ist. Hierbei bedeckt die besagte Vergussmasse 38 eine erste Basisplatte 2 der beiden Basisplatten 2,3 des Wärmeübertragers 1 abschnittsweise vollständig, dieser von der Vergussmasse 38 bedeckte Abschnitt der Basisplatte 2 ist dabei als Basisplattengroßfläche 39 bezeichnet. Diese ist bezüglich der besagten Trägergroßfläche 29 und der besagten Ebene 33 parallel.

Die erste Basisplatte 2 der beiden Basisplatten 2,3 hat im Bereich der Basisplattengroßfläche 39 mehrere sogenannte Rücksprünge 40, die man auch als Rücksprungabschnitte bezeichnen könnte, und mehrere Basisabschnitte 41. Die Rücksprünge 40 und die Basisabschnitte 41 unterteilen die Basisplattengroßfläche 39 sozusagen in alternierend aufeinanderfolgende unterschiedliche Bereiche. Die Rücksprünge 40 bilden sozusagen Vertiefungen, sie weisen in Richtung der Querachse 37 vom Spulenträger 25 weg und sind bezüglich der Basisplattengroßfläche 39 in Richtung der Querachse 37 weg vom Spulenträger 25 eingerückt. Nach Fig. 4 kann man auch erkennen, dass die Rücksprünge 40 jeweils in Richtung der Querachse 37 einem der besagten Versteifungskörper 28 der Versteifungsanordnung 27 gegenüberliegen. Die Basisabschnitte 41 sind dagegen jeweils in Richtung der Querachse 37 einem Ferritkörper 32 der Ferritanordnung 31 gegenüberliegend angeordnet. Durch diese Gestaltung werden zwischen dem Wärmeübertrager 1 und der Ferritanordnung 31, der Versteifungsanordnung 27 und dem Spulenträger 25 unterschiedlich große Abstände 42,43 definiert, nämlich ein erster Abstand 42 in Richtung der Querachse 37 zwischen einem jeweiligen Rücksprung 40 und der Ebene 33 und ein zweiter Abstand 43 in Richtung der Querachse 37 zwischen einem jeweiligen Basisabschnitt 41 und der Ebene 33. Zweckmäßigerweise ist ein erster Abstand 42 dabei stets größer als ein zweiter Abstand 43. Dadurch können die Rücksprünge 40 der ersten Basisplatte 2 der beiden Basisplatten 2,3 gemeinsam mit der zweiten Basisplatte 3 der beiden Basisplatten 2,3, an der exemplarisch die Elektronikanordnung 34 angeordnet ist, die ersten Kanalpassagen 8 der Kanalpassagen 8,9 des Wärmeübertragers 1 bilden. Die Basisabschnitte 41 bilden gemeinsam mit der zweiten Basisplatte 3 der beiden Basisplatten 2,3 die zweiten Kanalpassagen 9 der Kanalpassagen 8,9 des Wärmeübertragers 1.

## Patentansprüche

1. Wärmeübertrager (1) für eine Induktionsladeeinrichtung (24) eines Kraftfahrzeuges,
- mit zwei separaten miteinander dauerhaft verbundenen Basisplatten (2,3), welche ein einstückiges Wärmeübertragergehäuse (4) und einen Strömungskanal (5) bilden oder begrenzen, durch den sich ein Strömungspfad (6) für ein Wärmeübertragerfluid erstreckt,
- wobei der Strömungskanal (5) längs des Strömungspfads (6) von Wärmeübertragerfluid nacheinander durchströmbare Kanalpassagen (8,9) aufweist, die jeweils einen bezüglich des Strömungspfads (6) quer orientierten freien Strömungsquerschnitt (13,14) haben,
- wobei Strömungsquerschnitte (13) erster Kanalpassagen (8) dieser Kanalpassagen (8,9) flächenkleiner gestaltet sind als Strömungsquerschnitte (14) zweiter Kanalpassagen (9) dieser Kanalpassagen (8,9) und
- mit einer vollständig in den Strömungskanal (5) eingesetzten und vom Wärmeübertragerfluid durchströmbaren Strömungsleitanordnung (15) zum Leiten des Wärmeübertragerfluids,
**dadurch gekennzeichnet, dass**
- die Basisplatten (2,3) aus einem metallischen Werkstoff realisiert sind.

2. Wärmeübertrager (1) nach Anspruch 1,
**dadurch gekennzeichnet,**
**dass** die Strömungsleitanordnung (15) mehrere separate und jeweils einstückig gestaltete Leitelemente (16) aufweist.

3. Wärmeübertrager (1) nach Anspruch 2,
**dadurch gekennzeichnet,**
**dass** in jede der ersten Kanalpassagen (8) dieser Kanalpassagen (8,9) oder in jede der zweiten Kanalpassagen (9) dieser Kanalpassagen (8,9) oder in jede der ersten und zweiten Kanalpassagen (8,9) dieser Kanalpassagen (8,9) jeweils ein einziges Leitelement (16) eingesetzt ist.

4. Wärmeübertrager (1) nach Anspruch 2 oder 3,
**dadurch gekennzeichnet,**
**dass** die Leitelemente (16) jeweils an der einen und/oder anderen Basisplatte (2,3) formschlüssig und/oder kraftschlüssig wärmeleitend fixiert sind.

5. Wärmeübertrager (1) nach einem der Ansprüche 2 bis 4,
**dadurch gekennzeichnet,**
**dass** die Leitelemente (16) jeweils an der einen und/oder anderen Basisplatte (2,3) stoffschlüssig fixiert sind.

6. Wärmeübertrager (1) nach Anspruch 2 bis 5,
**dadurch gekennzeichnet,**
**dass** die Leitelemente (16) jeweils parallel zueinander ausgerichtete Leitkanäle (17) begrenzen oder bilden, die jeweils eine Kanallängsachse (18) definieren, wobei sich durch diese Leitkanäle (17) jeweils ein Strömungsteilpfad (19) des Strömungspfads (6) für das Wärmeübertragerfluid erstreckt, so dass die Leitkanäle (17) jeweils von Wärmeübertragerfluid durchströmbar sind.

7. Wärmeübertrager (1) nach Anspruch 6,
**dadurch gekennzeichnet,**
**dass** die Leitkanäle (17) eines jeweiligen Leitelements (16) einenends und anderenends in eine erste Kanalpassage (8) dieser Kanalpassagen (8,9) oder in eine zweite Kanalpassage (9) dieser Kanalpassagen (8,9) münden.

8. Wärmeübertrager (1) nach Anspruch 6 oder 7,
**dadurch gekennzeichnet,**
**dass** die Leitkanäle (17) eines jeweiligen Leitelements (16) jeweils einen durchströmbaren freien Leitquerschnitt (20) begrenzen oder bilden, welcher bezüglich der Kanallängsachse (18) dieses Leitkanals (17) quer orientiert und flächenmäßig durchgängig konstant und rechteckig ist.

9. Wärmeübertrager (1) nach einem der Ansprüche 2 bis 8,
**dadurch gekennzeichnet,**
- **dass** die Leitelemente (16) jeweils in einer Trapezform ausgeführt sind, und/oder
- **dass** die jeweiligen Leitelemente (16) als Gleichteile realisiert, also baugleich ausgeführt sind, und/oder
- **dass** die jeweiligen Leitelemente (16) aus einem Aluminiumwerkstoff hergestellt sind, und/oder
- **dass** die jeweiligen Leitelemente (16) aus einem gewellten oder gefalteten oder plissierten Blechwerkstoff hergestellt sind.

10. Wärmeübertrager (1) nach einem der vorangehenden Ansprüche,
**dadurch gekennzeichnet,**
- **dass** die Strömungsquerschnitte (13) der ersten Kanalpassagen (8) dieser Kanalpassagen (8,9) zueinander flächengleich sind, und
- **dass** die Strömungsquerschnitte (14) der zweiten Kanalpassagen (9) dieser Kanalpassagen (8,9) zueinander flächengleich sind.

11. Wärmeübertrager (1) nach einem der vorangehenden Ansprüche, **dadurch gekennzeichnet,**
**dass** die Strömungsquerschnitte (13) der ersten Kanalpassagen (8) dieser Kanalpassagen (8,9) flächenmäßig jeweils lediglich 9/10 oder 8/10 oder 7/10 oder 6/10 oder 5/10 oder 4/10 oder 3/10 oder 2/10 oder 1/10 der Fläche des Strömungsquerschnitts (14) einer zweiten Kanalpassage (9) dieser Kanalpassagen (8,9) einnehmen.

12. Wärmeübertrager (1) nach einem der vorangehenden Ansprüche,
**dadurch gekennzeichnet,**
**dass** die ersten Kanalpassagen (8) dieser Kanalpassagen (8,9) und die zweiten Kanalpassagen (9) dieser Kanalpassagen (8,9) längs des Strömungspfads (6) in alternierend abwechselnder Reihenfolge aufeinanderfolgen.

13. Wärmeübertrager (1) nach einem der vorangehenden Ansprüche,
**dadurch gekennzeichnet,**
**dass** das Wärmeübertragergehäuse (4) ein Ringgehäuse oder ein Vieleckgehäuse (22) ist, dessen Strömungskanal (5) einen ebenen Ringkanal (23) bildet, wobei sich durch den Ringkanal (23) ein ringförmiger Strömungspfad (6) für das Wärmeübertragerfluid erstreckt, wobei die ersten und zweiten Kanalpassagen (8,9) jeweils kreisausschnittförmig oder vieleckausschnittförmig gestaltet sind.

14. Wärmeübertrager (1) nach einem der vorangehenden Ansprüchen, **dadurch gekennzeichnet,**
**dass** der Wärmeübertrager (1) zwei weitere Kanalpassagen (10,11,12) aufweist, welche durch zwei am Wärmeübertragergehäuse (4) fixierte Anschlussstutzen (10) gebildet sind, wobei der eine Anschlussstutzen (10) einen Fluideinlass (11) und der andere Anschlussstutzen (10) einen Fluidauslass (12) bildet, wobei mittels des Fluideinlasses (11) Wärmeübertragerfluid in den Strömungskanal (5) einströmbar ist, wobei mittels des Fluidauslasses (12) Wärmeübertragerfluid aus dem Strömungskanal (5) ausströmbar ist.

15. Kraftfahrzeugseitige Induktionsladeeinrichtung (24) einsetzbar in einer Induktionsladevorrichtung zum Aufladen einer Traktionsbatterie eines Kraftfahrzeugs,
- mit einem unterbodenseitig in ein Kraftfahrzeug einbaubaren ebenen Spulenträger (25), welcher eine elektrisch kontaktierbare Spule (26) trägt und welcher durch eine Versteifungsanordnung (27) aus wenigstens einem Versteifungskörper (28) versteift ist,
- wobei die Versteifungskörper (28) längs zu einer Trägergroßfläche (29) des Spulenträgers (25) zueinander unter Ausbildung von freien Zwischenbereichen (30) beabstandet und sich jeweils an dieser Trägergroßfläche (29) abstützend am Spulenträger (25) fixiert sind,
- wobei in jeden dieser Zwischenbereiche (30) ein Ferritkörper (32) einer mehrere separate Ferritkörper (32) aufweisenden Ferritanordnung (31) eingelegt ist,
- wobei diese Ferritkörper (32) und diese Versteifungskörper (28) eine Ebene (33) aufspannen,
- mit einer Elektronikanordnung (34) aus wenigstens einem Elektronikkörper (35),
- mit einem Kühlelement (36) zum Kühlen der Induktionsladeeinrichtung (24), welches in Richtung einer senkrecht auf der Trägergroßfläche (29) stehenden Querachse (37) zwischen einerseits der Ferritanordnung (31), der Versteifungsanordnung (27) und dem Spulenträger (25) sowie andererseits der Elektronikanordnung (34) sandwichartig zwischengeschaltet ist, so dass die Elektronikanordnung (34) durch das Kühlelement (36) gegenüber der Ferritanordnung (31), der Versteifungsanordnung (27) und dem Spulenträger (25) abgegrenzt und abschirmbar oder abgeschirmt ist,
**dadurch gekennzeichnet, dass**
- die Ferritanordnung (31), die Versteifungsanordnung (27), der Spulenträger (25) und das Kühlelement (36) jeweils wenigstens abschnittsweise durch eine Wärmeleiteigenschaften aufweisende Vergussmasse (38) aneinander fixiert sind,
- das Kühlelement (36) ein Wärmeübertrager (1) nach wenigstens einem der vorangehenden Ansprüche ist,
- eine erste Basisplatte (2) der beiden Basisplatten (2,3) mittels der eine Basisplattengroßfläche (39) der ersten Basisplatte (2) vollständig bedeckenden Vergussmasse (38) an der Ferritanordnung (31), der Versteifungsanordnung (27) und dem Spulenträger (25) fixiert ist,
- die erste Basisplatte (2) der beiden Basisplatten (2,3) Rücksprünge (40) und Basisabschnitte (41) aufweist.

16. Induktionsladeeinrichtung (24) nach Anspruch 15,
**dadurch gekennzeichnet,**
- **dass** die Rücksprünge (40) und Basisabschnitte (41) im Bereich der Basisplattengroßfläche (39) der ersten Basisplatte (2) der beiden Basisplatten (2,3) angeordnet sind und diese segmentieren,
- wobei die Rücksprünge (40):
- in Richtung der Querachse (37) vom Spulenträger (25) wegweisen und
- bezüglich der Basisplattengroßfläche (39) der ersten Basisplatte (2) der beiden Basisplatten (2,3) in Richtung der Querachse (37) weg vom Spulenträger (25) eingerückt sind und
- jeweils in Richtung der Querachse (37) einem Versteifungskörper (28) der Versteifungsanordnung (27) gegenüberliegen,
- wobei die Basisabschnitte (41):
- jeweils in Richtung der Querachse (37) einem Ferritkörper (32) der Ferritanordnung (31) gegenüberliegen,
- wobei ein erster Abstand (42) in Richtung der Querachse (37) zwischen einem jeweiligen Rücksprung (40) und der Ebene (33) größer ist als ein zweiter Abstand (43) in Richtung der Querachse (37) zwischen einem jeweiligen Basisabschnitt (41) und der Ebene (33).

17. Induktionsladeeinrichtung (24) nach Anspruch 16,
**dadurch gekennzeichnet,**
- **dass** die Rücksprünge (40) der ersten Basisplatte (2) der beiden Basisplatten (2,3) gemeinsam mit der zweiten Basisplatte (3) der beiden Basisplatten (2,3) die ersten Kanalpassagen (8) der Kanalpassagen (8,9) des Wärmeübertragers (1) begrenzen oder bilden, und
- **dass** die Basisabschnitte (41) der ersten Basisplatte (2) der beiden Basisplatten (2,3) gemeinsam mit der zweiten Basisplatte (3) der beiden Basisplatten (2,3) die zweiten Kanalpassagen (9) der Kanalpassagen (8,9) des Wärmeübertragers (1) begrenzen oder bilden.

## Claims

1. Heat exchanger (1) for an induction charging device (24) of a motor vehicle,
- having two base plates (2, 3) permanently connected to one another which form or delimit an integral heat exchanger housing (4) and a flow duct (5) through which a flow path (6) or a heat exchanger fluid runs,
- wherein the flow duct (5) has duct passages (8, 9) along the flow path (6), through which successively heat exchanger fluid can flow, which have respectively a free flow cross-section (13, 14) oriented transversely with regard to the flow path (6),
- wherein flow cross-sections (13) of first duct passages (8) of these duct passages (8, 9) are smaller in area than flow cross-sections (14) of second duct passages (9) of these duct passages (8, 9) and
- having a flow guide arrangement (15) which are inset completely into the flow duct (5) and through which heat exchanger fluid can flow, for conducting the heat exchanger fluid,
**characterized in that**
- the base plates (2, 3) are made from a metallic material.

2. Heat exchanger (1) according to claim 1,
**characterized in that**
the flow guide arrangement (15) has several separate conducting elements (16) which are respectively integrally designed.

3. Heat exchanger (1) according to claim 2,
**characterized in that**
in each of the first duct passages (8) of these duct passages (8, 9) or in each of the second duct passages (9) of these duct passages (8, 9) or in each of the first and second duct passages (8, 9) of these duct passages (8, 9) is inset in each case one single conducting element (16).

4. Heat exchanger (1) according to claim 2 or 3,
**characterized in that**
the conducting elements (16) are fixed to the one and/or other base plate (2, 3) in a form-fitting and/or force-fitting manner so as to conduct heat.

5. Heat exchanger (1) according to any of claims 2 to 4,
**characterized in that**
the conducting elements (16) are fixed to the one and/or other base plate (2, 3) in a material-fitting manner.

6. Heat exchanger (1) according to claim 2 to 5,
**characterized in that**
the conducting elements (16) delimit or form in each case conducting ducts (17) aligned parallel to one another, which define respectively one duct longitudinal axis (18), wherein respectively one flow partial path (19) of the flow path (6) for the heat exchanger fluid extends through these conducting ducts (17) such that the conducting ducts (17) can be flowed through in each case by heat exchanger fluid.

7. Heat exchanger (1) according to claim 6,
**characterized in that**
the conducting ducts (17) of the respective conducting element (16) open at one end and the other end into a first duct passage (8) of these duct passages (8, 9) or into a second duct passage (9) of these duct passages (8, 9).

8. Heat exchanger (1) according to claim 6 or 7,
**characterized in that**
the conducting ducts (17) of a respective conducting element (16) delimit or form respectively one free conducting cross-section (20) through which can be flowed, which in respect of the duct longitudinal axis (18) of this conducting duct (17) is perpendicularly oriented and as regards area is constant and rectangular throughout.

9. Heat exchanger (1) according to any of claims 2 to 8,
**characterized in that**
- the conducting elements (16) are designed respectively in a trapezoid shape, and/or
- the respective conducting elements (16) are realized as identical parts, that is, are identical in construction, and/or
- the respective conducting elements (16) are manufactured from an aluminium material, and/or
- the respective conducting elements (16) are manufactured from a corrugated or folded or pleated material.

10. Heat exchanger (1) according to any of the preceding claims,
**characterized in that**
- the flow cross-sections (13) of the first duct passages (8) of these duct passages (8, 9) are of equal area to one another, and
- the flow cross-sections (14) of the second duct passages (9) of these duct passages (8, 9) are of equal area to one another.

11. Heat exchanger (1) according to any of the preceding claims,
**characterized in that**
the flow cross-sections (13) of the first duct passages (8) of these duct passages (8, 9) in terms of their area are respectively merely 9/10 or 8/10 or 7/10 or 6/10 or 5/10 or 4/10 or 3/10 or 2/10 or 1/10 of the area of the flow cross-section (14) of a second duct passage (9) of these duct passages (8, 9).

12. Heat exchanger (1) according to any of the preceding claims,
**characterized in that**
the first duct passages (8) of these duct passages (8, 9) and the second duct passages (9) of these duct passages (8, 9) follow one another along the flow path (6) in alternating order of succession.

13. Heat exchanger (1) according to any of the preceding claims,
**characterized in that**
the heat exchanger housing (4) is an annular housing or a polygonal housing (22), the flow duct (5) of which forms a flat annular duct (23), wherein an annular flow path (6) for the heat exchanger fluid extends through the annular duct (23), wherein the first and second duct passages (8, 9) are respectively circular cut-out or polygonal cut-out in form.

14. Heat exchanger (1) according to any of the preceding claims,
**characterized in that**
the heat exchanger (1) has two further duct passages (10, 11, 12) which are formed by two connecting pieces (10) fixed to the heat exchanger housing (4),
wherein one connecting piece (10) forms a fluid inlet (11) and the other connecting piece (10) forms a fluid outlet (12), wherein by means of the fluid inlet (11) heat exchanger fluid flows into the flow duct (5), wherein by means of the fluid outlet (12) heat exchanger fluid flows out of the flow duct (5).

15. Inductive charging device (24) on the motor vehicle side which can be used in an induction charging apparatus for charging a traction battery of a motor vehicle,
- having a flat coil carrier (25) which can be installed in a motor vehicle, which carries an electrically contactable oil (26) and which is stiffened by a stiffening arrangement (27) consisting of at least one stiffening body (28),
- wherein the stiffening bodies (28) are spaced apart from one another along a large support surface (29) of the coil carrier (25), forming free intermediate regions (30), and are each fixed to the coil carrier (25) so as to be supported on this large support surface (29),
- wherein into each of these intermediate regions (30) is laid a ferrite body (32) of a ferrite arrangement (31) having several separate ferrite bodies (32),
- wherein these are ferrite bodies (32) and these stiffening bodies (28) subtend one level (33),
- having an electronics arrangement (34) consisting of at least one electronics body (35),
- having a cooling element (36) for cooling the inductive charging device (24), which is connected in a sandwich-like manner in the direction of a transverse axis (37) standing perpendicularly on the large support surface (29) between on the one hand the ferrite arrangement (31), the stiffening arrangement (27) and the coil carrier (25) and on the other hand the electronics arrangement (34), such that the electronics arrangement (34) is segregated and is able to be shielded or is shielded by the cooling element (36) with respect to the ferrite arrangement (31), the stiffening arrangement (27) and the coil carrier (25),
**characterized in that**
- the ferrite arrangement (31), the stiffening arrangement (27), the coil carrier (25) and the cooling element (36) are fixed to one another respectively at least in some parts by a casting compound (38) having thermal conductive properties,
- the cooling element (36) is a heat exchanger (1) according to at least one of the preceding claims,
- a first base plate (2) of the two base plates (2, 3) is fixed to the ferrite arrangement (31), the stiffening arrangement (27) and the coil carrier (25) by means of the casting compound (38) which completely covers a large base plate surface (39) of the first base plate (2),
- the first base plate (2) of the two base plates (2, 3) has recesses (40) and base portions (41).

16. Inductive charging device (24) according to claim 15,
**characterized in that**
- the recesses (40) and base portions (41) are arranged in the region of the large base plate surface (39) of the first base plate (2) of the two base plates (2, 3), and segment this,
- wherein the recesses (40):
- point in the direction of the transverse axis (37) of the coil carrier (25) and
- with regard to the large base plate surface (39) of the first base plate (2) of the two base plates (2, 3) are indented in the direction of the transverse axis (37) away from the oil carrier (25) and
- are respectively opposite a stiffening body (28) of the stiffening arrangement (27) in the direction of the transverse axis (37),
- wherein the base portions (41):
- are respectively opposite a ferrite body (32) of the ferrite arrangement (31) in the direction of the transverse axis (37),
- wherein a first spacing (42) in the direction of the transverse axis (37) between a respective recess (40) and the plane (33) is greater than a second spacing (43) in the direction of the transverse axis (37) between a respective base portion (41) and the plane (33).

17. Inductive charging device (24) according to claim 16,
**characterized in that**
- the recesses (40) of the first base plate (2) of the two base plates (2, 3) together with the second base plate (3) of the two base plates (2, 3) delimit or form the first duct passages (8) of the duct passages (8, 9) of the heat exchanger (1), and
- the base portions (41) of the first base plate (2) of the two base plates (2, 3) together with the second base plate (3) of the two base plates (2, 3) delimit or form the second duct passages (9) of the duct passages (8, 9) of the heat exchanger (1).

## Revendications

1. Échangeur de chaleur (1) pour un dispositif de charge inductive (24) d'un véhicule automobile,
- avec deux plaques de base (2, 3) séparées reliées l'une à l'autre durablement qui forment ou délimitent un boîtier d'échangeur de chaleur (4) d'un seul tenant et un canal d'écoulement (5), à travers lequel un trajet d'écoulement (6) pour un fluide d'échangeur de chaleur s'étend,
- dans lequel le canal d'écoulement (5) présente le long du trajet d'écoulement (6) des passages de canal (8, 9) pouvant être traversés les uns après les autres par du fluide d'échangeur de chaleur, qui présentent respectivement une section transversale d'écoulement (13, 14) libre orientée transversalement par rapport au trajet d'écoulement (6),
- dans lequel des sections transversales d'écoulement (13) de premiers passages de canal (8) de ces passages de canal (8, 9) sont conçues pour être plus plates que les sections transversales d'écoulement (14) de seconds passages de canal (9) de ces passages de canal (8, 9) et
- avec un ensemble de guidage d'écoulement (15) pouvant être traversé par du fluide d'échangeur de chaleur et inséré complètement dans le canal d'écoulement (5) pour le guidage du fluide d'échangeur de chaleur,
**caractérisé en ce que**
- les plaques de base (2, 3) sont réalisées en un matériau métallique.

2. Échangeur de chaleur (1) selon la revendication 1,
**caractérisé en ce que**
l'ensemble de guidage d'écoulement (15) présente plusieurs éléments de guidage (16) séparés et conçus d'un seul tenant respectivement.

3. Échangeur de chaleur (1) selon la revendication 2,
**caractérisé en ce que**
dans respectivement un seul élément de guidage (16) est inséré chacun des premiers passages de canal (8) de ces passages de canal (8, 9) ou dans chacun des seconds passages de canal (9) de ces passages de canal (8, 9) ou dans chacun des premier et second passages de canal (8, 9) de ces passages de canal (8, 9).

4. Échangeur de chaleur (1) selon la revendication 2 ou 3,
**caractérisé en ce que**
les éléments de guidage (16) sont fixés de manière thermoconductrice respectivement au niveau de l'une et/ou l'autre plaque de base (2, 3) par complémentarité de formes et/ou à force.

5. Échangeur de chaleur (1) selon l'une quelconque des revendications 2 à 4,
**caractérisé en ce que**
les éléments de guidage (16) sont fixés respectivement au niveau de l'une et/ou l'autre plaque de base (2, 3) par matière.

6. Échangeur de chaleur (1) selon la revendication 2 à 5,
**caractérisé en ce que**
les éléments de guidage (16) délimitent ou forment respectivement des canaux de guidage (17) orientés parallèlement l'un à l'autre qui définissent respectivement un axe longitudinal de canal (18), dans lequel respectivement un trajet partiel d'écoulement (19) du trajet d'écoulement (6) pour le fluide d'échangeur de chaleur s'étend à travers ces canaux de guidage (17) de sorte que les canaux de guidage (17) puissent être traversés respectivement par du fluide d'échangeur de chaleur.

7. Échangeur de chaleur (1) selon la revendication 6,
**caractérisé en ce que**
les canaux de guidage (17) d'un élément de guidage respectif (16) au niveau d'une extrémité et de l'autre extrémité débouchent dans un premier passage de canal (8) de ces passages de canal (8, 9) ou dans un second passage de canal (9) de ces passages de canal (8, 9).

8. Échangeur de chaleur (1) selon la revendication 6 ou 7,
**caractérisé en ce que**
les canaux de guidage (17) d'un élément de guidage (16) respectif délimitent ou forment respectivement une section transversale de guidage (20) libre pouvant être traversée, qui est orientée transversalement par rapport à l'axe longitudinal de canal (18) de ce canal de guidage (17) et est rectangulaire et constante en continu sur la surface.

9. Échangeur de chaleur (1) selon l'une quelconque des revendications 2 à 8,
**caractérisé en ce que**
- les éléments de guidage (16) sont réalisés respectivement dans une forme de trapèze, et/ou
- les éléments de guidage (16) respectifs sont réalisés comme des pièces identiques, donc sont réalisés avec une même construction, et/ou
- les éléments de guidage (16) respectifs sont fabriqués en un matériau d'aluminium, et/ou
- les éléments de guidage (16) respectifs sont fabriqués en un matériau de tôle ondulé ou plié ou plissé.

10. Échangeur de chaleur (1) selon l'une quelconque des revendications précédentes,
**caractérisé en ce que**
- les sections transversales d'écoulement (13) des premiers passages de canal (8) de ces passages de canal (8, 9) sont de même surface, et
- les sections transversales d'écoulement (14) des seconds passages de canal (9) de ces passages de canal (8, 9) sont de même surface.

11. Échangeur de chaleur (1) selon l'une quelconque des revendications précédentes,
**caractérisé en ce que**
les sections transversales d'écoulement (13) des premiers passages de canal (8) de ces passages de canal (8, 9) occupent sur la surface respectivement juste 9/10 ou 8/10 ou 7/10 ou 6/10 ou 5/10 ou 4/10 ou 3/10 ou 2/10 ou 1/10 de la surface de la section transversale d'écoulement (14) d'un second passage de canal (9) de ces passages de canal (8, 9).

12. Échangeur de chaleur (1) selon l'une quelconque des revendications précédentes,
**caractérisé en ce que**
les premiers passages de canal (8) de ces passages de canal (8, 9) et les seconds passages de canal (9) de ces passages de canal (8, 9) se suivent le long du trajet d'écoulement (6) dans l'ordre alterné.

13. Échangeur de chaleur (1) selon l'une quelconque des revendications précédentes,
**caractérisé en ce que**
le boîtier d'échangeur de chaleur (4) est un boîtier annulaire ou un boîtier polygonal (22), dont le canal d'écoulement (5) forme un canal annulaire (23) plan, dans lequel un trajet d'écoulement (6) annulaire pour le fluide d'échangeur de chaleur s'étend à travers le canal annulaire (23), dans lequel les premiers et seconds passages de canal (8, 9) sont conçus respectivement en segment de cercle ou en découpe polygonale.

14. Échangeur de chaleur (1) selon l'une quelconque des revendications précédentes,
**caractérisé en ce que**
l'échangeur de chaleur (1) présente deux autres passages de canal (10, 11, 12) qui sont formés par deux tubulures de raccordement (10) fixées au boîtier d'échangeur de chaleur (4)
dans lequel l'une tubulure de raccordement (10) forme une entrée de fluide (11) et l'autre tubulure de raccordement (10) forme une sortie de fluide (12), dans lequel du fluide d'échangeur de chaleur peut être admis dans le canal d'écoulement (5) au moyen de l'entrée de fluide (11), dans lequel du fluide d'échangeur de chaleur peut être sorti du canal d'écoulement (5) au moyen de la sortie de fluide (12).

15. Dispositif de charge inductive (24) côté véhicule automobile insérable dans un dispositif de charge inductive pour la charge d'une batterie de traction d'un véhicule automobile,
- avec un porte-bobine (25) plan pouvant être intégré côté dessous de caisse dans un véhicule automobile qui porte une bobine (26) pouvant être en contact électrique et qui est rigidifié par un agencement de raidissement (27) composé d'au moins un corps de raidissement (28),
- dans lequel les corps de raidissement (28) sont espacés le long d'une grande surface de support (29) du porte-bobine (25) les uns par rapport aux autres en réalisant des zones intermédiaires (30) libres et sont fixés respectivement en appui contre cette grande surface de support (29) au porte-bobine (25),
- dans lequel un corps de ferrite (32) d'un agencement de ferrite (31) présentant plusieurs corps de ferrite (32) séparés est introduit dans chacune de ces zones intermédiaires (30),
- dans lequel ces corps de ferrite (32) et ces corps de raidissement (28) définissent un plan (33),
- avec un agencement électronique (34) composé d'au moins un corps électronique (35),
- avec un élément de refroidissement (36) pour le refroidissement du dispositif de charge inductive (24) qui est intercalé en sandwich en direction d'un axe transversal (37) se trouvant perpendiculaire à la grande surface de support (29) entre d'une part l'agencement de ferrite (31), l'agencement de raidissement (27) et le porte-bobine (25) ainsi que d'autre part l'agencement électronique (34) de sorte que l'agencement électronique (34) soit limité et blindable ou blindé par l'élément de refroidissement (36) par rapport à l'agencement de ferrite (31), l'agencement de raidissement (27) et le porte-bobine (25),
**caractérisé en ce que**
- l'agencement de ferrite (31), l'agencement de raidissement (27), le porte-bobine (25) et l'élément de refroidissement (36) sont fixés les uns aux autres respectivement au moins par sections par une masse de scellement (38) présentant des propriétés thermoconductrices,
- l'élément de refroidissement (36) est un échangeur de chaleur (1) selon au moins l'une quelconque des revendications précédentes,
- une première plaque de base (2) des deux plaques de base (2, 3) est fixée au moyen de la masse de scellement (38) recouvrant complètement une grande surface de plaque de base (39) de la première plaque de base (2) à l'agencement de ferrite (31), à l'agencement de raidissement (27) et au porte-bobine (25),
- la première plaque de base (2) des deux plaques de base (2, 3) présente des retraits (40) et des sections de base (41).

16. Dispositif de charge inductive (24) selon la revendication 15,
**caractérisé en ce que**
- les retraits (40) et les sections de base (41) sont agencés dans la zone de la grande surface de plaque de base (39) de la première plaque de base (2) des deux plaques de base (2, 3) et segmentent celle-ci,
- dans lequel les retraits (40) :
- sont tournés en direction de l'axe transversal (37) loin du porte-bobine (25) et
- sont dentelés par rapport à la grande surface de plaque de base (39) de la première plaque de base (2) des deux plaques de base (2, 3) en direction de l'axe transversal (37) loin du porte-bobine (25) et
- sont opposés respectivement en direction de l'axe transversal (37) à un corps de raidissement (28) de l'agencement de raidissement (27),
- dans lequel les sections de base (41) :
- sont opposées respectivement en direction de l'axe transversal (37) à un corps de ferrite (32) de l'agencement de ferrite (31),
- dans lequel une première distance (42) en direction de l'axe transversal (37) entre un retrait (40) respectif et le plan (33) est supérieure à une seconde distance (43) en direction de l'axe transversal (37) entre une section de base (41) respective et le plan (33).

17. Dispositif de charge inductive (24) selon la revendication 16,
**caractérisé en ce que**
- les retraits (40) de la première plaque de base (2) des deux plaques de base (2, 3) délimitent ou forment conjointement avec la seconde plaque de base (3) des deux plaques de base (2, 3) les premiers passages de canal (8) des passages de canal (8, 9) de l'échangeur de chaleur (1), et
- les sections de base (41) de la première plaque de base (2) des deux plaques de base (2, 3) délimitent ou forment conjointement avec la seconde plaque de base (3) des deux plaques de base (2, 3) les seconds passages de canal (9) des passages de canal (8, 9) de l'échangeur de chaleur (1).
